# EUROPÄISCHE PATENTSCHRIFT

(11) **EP 4 373 662 B1**
(45) Veröffentlichungstag und Bekanntmachung des Hinweises auf die Patenterteilung: **03.09.2025**
(21) Anmeldenummer: 22809098.1
(22) Anmeldetag: 25.10.2022
(51) Int. Cl.: B30B 15/06, C23C 14/06, B44B 5/02, C23C 14/04, C23C 14/35, B30B 3/00, B44C 3/02

(54) **PRESSWERKZEUG UND VERFAHREN ZUM HERSTELLEN EINES PRESSBLECHS**
PRESS TOOL AND METHOD FOR PRODUCING A PRESS PLATE
OUTIL DE PRESSE ET PROCÉDÉ DE PRODUCTION DE PLAQUE DE PRESSE

(30) Priorität: 04.11.2021 DE 102021128738
(43) Veröffentlichungstag der Anmeldung: 29.05.2024
(73) Patentinhaber: HUECK Rheinische GmbH, 41747 Viersen (DE)
(72) Erfinder: KAOUK, Ali, 41751 Viersen (DE); HAGEDORN, Thorsten, 47807 Krefeld (DE); THÖLEN, Berthold, 41748 Viersen (DE)
(74) Vertreter: Burger, Hannes Alfred
(86) Internationale Anmeldenummer: PCT/EP2022/079756
(87) Internationale Veröffentlichungsnummer: WO 2023/078730

(56) Entgegenhaltungen:
- EP-A1- 1 063 085
- EP-A1- 2 497 650
- CH-A5- 681 083
- DE-A1- 102019 127 659

## Beschreibung

Die Erfindung betrifft ein Presswerkzeug mit einer Pressoberfläche und ein Verfahren zum Herstellen des Presswerkzeugs.

Presswerkzeuge z.B. in Form von Pressblechen, Endlosbändern oder Prägewalzen werden insbesondere in der holzverarbeitenden Industrie eingesetzt, um z.B. Möbel, Laminate oder Paneele, also allgemein Werkstücke herzustellen. Die Werkstücke werden mit der Pressoberfläche des Presswerkzeugs verpresst, sodass die Werkstücke Oberflächen entsprechend der Pressoberfläche erhalten.

Die WO 2009/062488 A2 offenbart ein Verfahren zur Bearbeitung einer strukturierten Pressoberfläche eines Prägewerkzeugs. Die Oberfläche mit einer ersten Chromschicht vollflächig versehen, auf der in vorbestimmten Bereichen zumindest eine weitere Chromschicht angeordnet wird. Die Glanzgrade der beiden Chromschichten unterscheidet sich. Mittels der Pressoberfläche kann ein als Werkstoffplatte ausgebildetes Werkstück mit einer strukturierten Oberfläche hergestellt werden, die unterschiedliche Glanzgrade aufweist. Aufgrund der Verwendung der Chromschichten ist die Herstellung dieses Presswerkzeugs relativ umweltschädlich.

Die US 6,190,514 B1 offenbart ein Verfahren zum Herstellen einer ebenen Pressoberfläche, um aus mit Harz imprägniertem Papier ein dekoratives Laminat herzustellen. Dazu wird ein gewünschtes Finish auf einer ebenen Pressoberfläche erzeugt, Verunreinigungen von der ebenen Oberfläche entfernt und die ebene Oberfläche mit Hafniumdiborid, Molybdändiborid, Tantaldiborid, Titandiborid, Wolframdiborid, Vanadiumdiborid, Zirkondiborid oder Mischungen dieser Stoffe in einem Flächenmagnetronsputter-Beschichtungssystem auf eine Vickershärte von mindestens 2000 HV beschichtet, indem durch Bewegen der ebenen Oberfläche und ein Sputterkopf des Flächenmagnetronsputter-Beschichtungssystems relativ zueinander mit einer Scangeschwindigkeit ausgeführt wird, die ausreicht, um in der ebenen Pressoberfläche einen thermischen Gradienten von 27,78°C oder weniger zu erzeugen.

EP 1 063 085 A1 offenbart ein Presswerkzeug gemäss dem Oberbegriff des Anspruchs 1.

Die Aufgabe der Erfindung ist es, ein Presswerkzeug mit einer Pressoberfläche mit bereichsweise unterschiedlichen Glanzgraden anzugeben, deren Herstellung relativ umweltfreundlich ist.

Die Aufgabe der Erfindung wird gelöst durch ein Presswerkzeug zum Herstellen eines Werkstücks gemäss Anspruch 1 und ein Verfahren zum Herstellen eines

Presswerkzeugs gemäss Anspruch 8.

Das erfindungsgemässe Presswerkzeug umfasst eine Pressoberfläche, eine Grundstruktur, und zumindest zwei auf der Oberfläche übereinander angeordnete Keramikschichten, die die Pressoberfläche bilden, von denen eine der Keramikschichten eine vollflächige Keramikschicht mit einem Glanzgrad und die andere eine partielle Keramikschicht mit einem weiteren Glanzgrad ist, der sich vom Glanzgrad der vollflächigen Keramikschicht unterscheidet.

Das erfindungsgemäße Presswerkzeug ist z.B. ein Endlosband oder eine Prägewalze. Vorzugsweise ist das das erfindungsgemäße Presswerkzeug Pressblech.

Die Pressoberfläche ist z.B. glatt, kann aber auch als eine strukturierte Pressoberfläche ausgeführt sein. Insbesondere kann somit die Pressoberfläche eine Struktur aus Erhebungen und Vertiefungen aufweisen, und die Grundstruktur eine strukturierte Oberfläche entsprechend der Struktur der Pressoberfläche.

Ein weiterer Aspekt der Erfindung ist ein Verfahren zum Herstellen des erfindungsgemäßen Presswerkzeugs, aufweisend folgende Verfahrensschritte:
- Bereitstellen der Grundstruktur,
- Auftragen einer der Keramikschichten auf die Oberfläche der Grundstruktur, und
- Auftragen einer weiteren der Keramikschichten auf die auf der strukturierten Oberfläche aufgetragenen Keramikschicht, wobei sich die Glanzgrade der beiden Keramikschichten unterscheiden.

Das erfindungsgemäße Presswerkzeug umfasst demnach die Grundstruktur, die gemäß einer Variante eine strukturierte Oberfläche entsprechend der ggf. als strukturierte Pressoberfläche ausgebildeten Pressoberfläche aufweist. Die Grundstruktur umfasst z.B. mehrere, übereinander angeordnete partielle Metallschichten, die die Oberfläche der Grundstruktur bilden, wie es beispielsweise aus der in der Einleitung genannten WO 2009/062488 A2 bekannt ist.

Um eine relativ harte Pressoberfläche zu erhalten, wird jedoch erfindungsgemäß diese Oberfläche nicht mit einer Chromschicht versehen, sondern mit den Keramikschichten. Keramik kann ebenfalls relativ hart ausgeführt sein und kann z.B. Vickershärte von mindestens 2000 HV aufweisen. Geeignete Keramikmaterialien der Keramikschichten sind z.B. Hafniumdiborid, Molybdändiborid, Tantaldiborid, Titandiborid, Wolframdiborid, Vanadiumdiborid, Zirkondiborid oder Mischungen dieser Keramikmaterialien. Das Auftragen bzw. Beschichten der Keramikschichten ist im Vergleich zum Auftragen bzw. Beschichten mit der Chromschicht deutlich umweltschonender.

Des Weiteren umfasst das erfindungsgemäße Presswerkzeug zumindest zwei übereinander angeordnet Keramikschichten, vorzugsweise genau zwei übereinander angeordnete Keramikschichten. Eine der Keramikschichten ist eine partielle und die andere ist ein vollflächige. Dadurch, dass sich erfindungsgemäß die Glanzgrade der vollflächigen von der partiellen Keramikschicht unterscheiden, weist die Pressoberfläche in unterschiedlichen Bereichen unterschiedliche Glanzgrade auf, wodurch die Oberfläche des mit dem Pressblech hergestellt Werkstücks ebenfalls bereichsweise entsprechend unterschiedliche Glanzgrade aufweist. Dadurch kann die Qualität der durch Verpressen mit der Pressoberfläche entstehenden Werkstücke verbessert werden. Werkstücke sind z.B. Werkstoffplatten, insbesondere Laminate oder Paneele.

Insbesondere ist es auch möglich, eine abgenutzte oder beschädigte Keramikschicht von der Grundstruktur relativ einfach zu entfernen, um die Grundstruktur neu mit Keramikschichten zu versehen. Dadurch ergibt sich eine relativ kostengünstige Reparatur eines abgenutzten oder beschädigten Presswerkzeugs.

Das Auftragen der Keramikschichten kann z.B. mittels eines Flächenmagnetronsputter-Beschichtungssystems erfolgen.

Die Dicken der beiden Keramikschichten liegen vorzugsweise im Bereich zwischen 1µm und 2µm.

Um die unterschiedlichen Glanzgrade der vollflächigen und der partiellen Keramikschicht zu erhalten, unterscheidet sich vorzugsweise die Dicke der vollflächigen Keramikschicht von der Dicke der partiellen Keramikschicht. Es ist nämlich möglich, den Glanzgrad der entsprechenden Keramikschicht über deren Dicke einzustellen. In diesem Fall bestehen die beiden Keramikschichten vorzugsweise aus demselben Keramikmaterial, was sich positiv auf die Herstellungskosten des erfindungsgemäßen Presswerkzeugs auswirken kann. Die erforderliche Dicke der Keramikschichten kann bei der Herstellung des Pressblechs z.B. durch ein geeignetes Ansteuern des Flächenmagnetronsputter-Beschichtungssystems erfolgen.

Der Glanzgrad der beiden Keramikschichten kann auch durch die Verwendung unterschiedlicher Keramikmaterialien für die partielle und die vollflächige Keramikschicht eingestellt werden. Gemäß einer Variante des erfindungsgemäßen Pressblechs können sich daher die Keramikmaterialien der beiden Keramikschichten unterscheiden, um die unterschiedlichen Glanzgrade der vollflächigen und der partiellen Keramikschicht zu erhalten. In diesem Fall ist insbesondere die Dicke der vollflächigen Keramikschicht gleich der Dicke der partiellen Keramikschicht.

Vorzugsweise ist die partielle Keramikschicht zwischen der vollflächigen Keramikschicht und der Oberfläche des Grundstruktur angeordnet. Diese Ausführungsform des erfindungsgemäßen Pressblechs kann z.B. hergestellt werden durch
- Auftragen einer partiellen Maske auf die Oberfläche der Grundstruktur,
- Auftragen einer Keramikschicht auf der mit der Maske versehenen Oberfläche in Bereichen, die nicht von der Maske bedeckt sind,
- Entfernen der Maske, sodass auf der strukturierten Oberfläche die partielle Keramikschicht angeordnet ist, und
- Auftragen der vollflächigen Keramikschicht auf die partielle Keramikschicht.

Die partielle Keramikschicht kann aber z.B. auch durch geeignetes Ansteuern des Flächenmagnetronsputter-Beschichtungssystems hergestellt werden.

Da gemäß dieser Variante des Presswerkzeugs die vollflächige Keramikschicht auf der partiellen Keramikschicht aufgetragen ist, kann in relativ einfacher Weise eine relativ glatte Pressoberfläche hergestellt werden. In diesem Fall muss jedoch die vollflächige Keramikschicht derart beschaffen sein, dass sie den Glanzgrad der darunterliegenden partiellen Keramikschicht nicht völlig überdeckt. Insbesondere ist in diesem Fall die vollflächige Keramikschicht dünner als die partielle Keramikschicht, d.h. die Dicker der vollflächige Keramikschicht ist kleine als die Dicke der partielle Keramikschicht.

Das erfindungsgemäße Presswerkzeug kann aber auch derart ausgestaltet sein, dass die vollflächige Keramikschicht zwischen der partiellen Keramikschicht und der strukturierten Oberfläche der Grundstruktur angeordnet, d.h. dass die partielle Keramikschicht auf der vollflächigen Keramikschicht aufgetragen ist. Diese Ausführungsform des erfindungsgemäßen Presswerkzeugs kann z.B. hergestellt werden durch
- Auftragen der vollflächigen Keramikschicht auf die Oberfläche der Grundstruktur,
- Auftragen einer partiellen Maske auf die vollflächige Keramikschicht,
- Auftragen einer Keramikschicht auf der mit der Maske versehenen vollflächigen Keramikschicht in Bereichen, die nicht von der Maske bedeckt sind,
- Entfernen der Maske, sodass auf der vollflächigen Keramikschicht die partielle Keramikschicht angeordnet ist.

Die partielle Keramikschicht kann aber z.B. auch durch geeignetes Ansteuern des Flächenmagnetronsputter-Beschichtungssystems hergestellt werden.

Die Glanzgrade der partiellen und der vollflächigen Keramikschichten kann auch durch ein Nachbehandeln der entsprechenden aufgetragenen Keramikschicht erfolgen, um einen vorgegebenen Glanzgrad der entsprechenden Keramikschicht zu erhalten. Ein Nachbehandeln kann z.B. ein Polieren oder ein Laserbehandeln der entsprechenden Keramikschicht umfassen.

Gemäß einer Ausführungsform des erfindungsgemäßen Presswerkzeugs kann die die Oberfläche der Grundstruktur in unterschiedlichen Bereichen unterschiedliche Glanzgrade aufweisen, die sich insbesondere von den Glanzgraden der vollflächigen und der partiellen Keramikschicht unterscheiden. Das Einstellen der unterschiedlichen Glanzgrade der Oberfläche der Grundstruktur kann z.B. mittels eines Lasers erfolgen oder ist im Falle der Grundstruktur aus mehreren, übereinander angeordneten aus der WO 2009/062488 A2 bekannt.

Ausführungsbeispiele der Erfindung sind exemplarisch in den beigefügten schematischen Figuren dargestellt. Es zeigen:
- Fig. 1: ein Pressblech mit einer Pressoberfläche in einer perspektivischen Darstellung,
- Fig. 2: einen Ausschnitt einer Seitenansicht des Pressblechs in geschnittener Darstellung, und
- Fig. 3: Zwischenstadien des Pressblechs während seiner Herstellung.

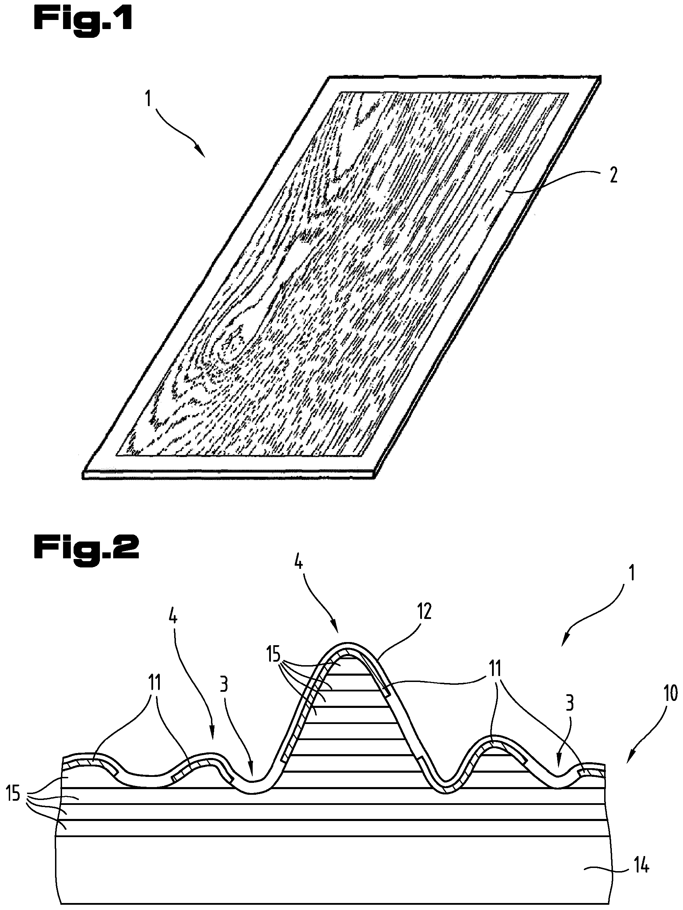

Die Fig. 1 zeigt in einer perspektivischen Darstellung ein Presswerkzeug, das im Falle des vorliegenden Ausführungsbeispiels als ein Pressblech 1 ausgebildet ist Das Pressblech umfasst eine Pressoberfläche 2. Die Fig. 2 zeigt einen Ausschnitt einer Seitenansicht des Pressblechs 1 in geschnittener Darstellung.

Die Pressoberfläche 2 kann glatt ausgeführt sein, umfasst jedoch im Falle des vorliegenden Ausführungsbeispiels eine Struktur aus den Erhebungen 4 und Vertiefungen 3.

Die Struktur der Pressoberfläche 2 ist insbesondere einem natürlichen Werkstoff, im Falle des vorliegenden Ausführungsbeispiels Holz zugeordnet.

Mit dem Pressblech 1 kann ein Werkstück, z.B. eine Werkstoffplatte, beispielsweise ein Laminat, durch Verpressen hergestellt werden. Nach dem Verpressen weist das Werkstück eine der Struktur der Pressoberfläche 2 entsprechende strukturierte Oberfläche auf.

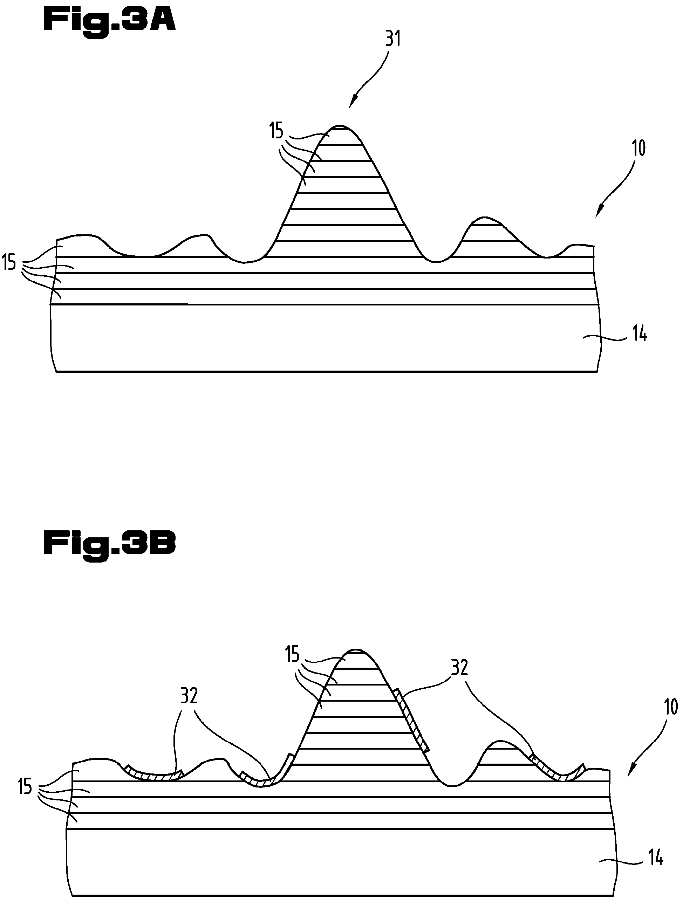

Das Pressblech 1 umfasst im Falle des vorliegenden Ausführungsbeispiels eine in der Fig. 3A gezeigte Grundstruktur 10 mit einer der Struktur der Pressoberfläche 2 zugeordneten strukturierten Oberfläche 31.

Das Pressblech 1 umfasst im Falle des vorliegenden Ausführungsbeispiels eine auf der strukturierten Oberfläche 31 der Grundstruktur 10 angeordnete partielle Keramikschicht 11 und eine auf der partiellen Keramikschicht 11 angeordnete vollflächige Keramikschicht 12, die die Pressoberfläche 2 bildet.

Die Grundstruktur 10 ist im Falle des vorliegenden Ausführungsbeispiels aus Metall.

Im Falle des vorliegenden Ausführungsbeispiels umfasst das Pressblech 1 einen Grundträger, insbesondere eine Grundträgerplatte 14 z.B. aus Metall, auf der die Grundstruktur 10 angeordnet ist.

Im Falle des vorliegenden Ausführungsbeispiels umfasst die Grundstruktur 10 mehrere, übereinander liegende Grundmetallschichten 15. Die Grundmetallschichten 15 sind vorzugsweise aus Nickel und sind zumindest teilweise partiell ausgeführt.

Die Grundstruktur 10 kann z.B. hergestellt werden, indem eine nicht näher dargestellt Maske zumindest einmal auf eine Grundmetallschicht 15 in Abhängigkeit von der Struktur der strukturierten Pressoberfläche 2 zugeordneten Bilddaten aufgetragen wird, um Bereiche abzudecken, und anschließend eine weitere Grundmetallschicht 15 auf die von dieser Maske nicht abgedeckten Bereiche aufgetragen wird. Dies wird wiederholt, bis die Grundstruktur 10 entstanden ist. Die Grundstruktur 10 wird insbesondere in Abhängigkeit von der Struktur der Pressoberfläche 2, d.h. in Abhängigkeit der Erhebungen 4 und Vertiefungen 5 zugeordneten Bilddaten hergestellt, indem in Abhängigkeit dieser Bilddaten die Masken und die Grundmetallschichten 15 z.B. mittels eines galvanischen oder chemischen Verfahrens nacheinander aufgetragen werden.

Auf die strukturierte Oberfläche 31 der Grundstruktur 10 wird anschließend im Falle des vorliegenden Ausführungsbeispiels eine in der Fig. 3B gezeigte Maske 32 aufgetragen, die die strukturierte Oberfläche 31 der Grundstruktur 10 partiell bedeckt.

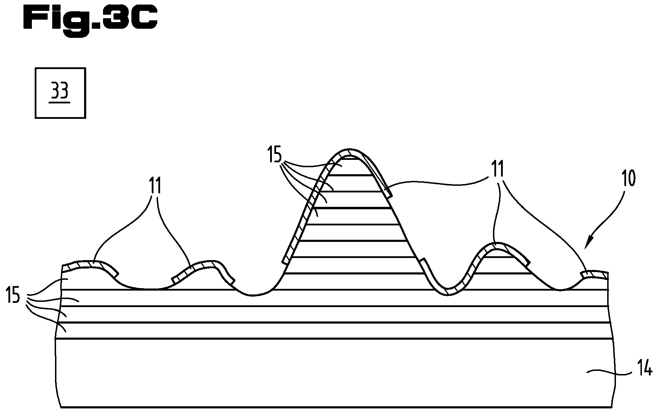

Anschließend wird im Falle des vorliegenden Ausführungsbeispiels mittels eines Flächenmagnetronsputter-Beschichtungssystems 33 auf die von der Maske 32 nicht bedeckten Bereiche der strukturierten Oberfläche 31 der Grundstruktur 10 eine Keramikschicht aufgetragen. Anschließend wird die Maske 32 entfernt, sodass lediglich die nicht von der Maske 32 bedeckten Bereiche der strukturierten Oberfläche 31 der Grundstruktur 10 mit der Keramikschicht bedeckt sind, wodurch die partielle Keramikschicht 11 entsteht, siehe Fig. 3c. Durch geeignetes Ansteuern des Flächenmagnetronsputter-Beschichtungssystems 33 erhält die partielle Keramikschicht 11 eine vorgegebene Dicke, wodurch sie einen vorgegebenen Glanzgrad erhält.

Anschließend wird im Falle des vorliegenden Ausführungsbeispiels mittels des Flächenmagnetronsputter-Beschichtungssystems 33 die vollflächige Keramikschicht 12 auf die partielle Keramikschicht 11 aufgetragen. Um den Glanzgrad der vollflächigen Keramikschicht 12 einzustellen, erhält diese, gesteuert durch das Flächenmagnetronsputter-Beschichtungssystem 33, eine vorgegebene Dicke.

Im Falle des vorliegenden Ausführungsbeispiels sind die beiden Keramikschichten 11, 12 aus demselben Keramikmaterial, z.B. aus Hafniumdiborid, Molybdändiborid, Tantaldiborid, Titandiborid, Wolframdiborid, Vanadiumdiborid, Zirkondiborid oder Mischungen dieser Keramikmaterialien.

Damit die Keramikschichten 11, 12 unterschiedliche Glanzgrade aufweisen, unterscheiden sich im Falle des vorliegenden Ausführungsbeispiels die Dicken der beiden Keramikschichten. Insbesondere ist die vollflächige Keramikschicht 12 dünner als die partielle Keramikschicht 11. Insbesondere bestehen die beiden Keramikschichten 11,12 aus demselben Keramikmaterial.

Die Dicken der beiden Keramikschichten 11, 12 liegen vorzugsweise im Bereich zwischen 1µm und 2µm.

Die Keramikschichten weisen vorzugsweise Vickershärte von mindestens 2000 HV auf.

Um unterschiedliche Glanzgrade der Keramikschichten 11, 12 einzustellen, können diese auch unterschiedliche Keramikmaterialien aufweisen.

Um die Glanzgrade der Keramikschichten 11, 12 einzustellen, können diese auch einer Nachbehandlung z.B. einem Polieren oder einer Laserbehandlung unterzogen werden.

Es ist auch möglich, die strukturierte Oberfläche 31 der Grundstruktur 10 zunächst mit der vollflächigen Keramikschicht 12 zu versehen und auf diese die partielle Keramikschicht 11 aufzutragen.

Es ist auch möglich, die partielle Keramikschicht 11 durch geeignetes Ansteuern des Flächenmagnetronsputter-Beschichtungssystems 33 herzustellen.

## Patentansprüche

1. Presswerkzeug zum Herstellen eines Werkstücks, aufweisend eine Pressoberfläche (2),
eine Grundstruktur (10), die eine Oberfläche (31) aufweist, und
zumindest zwei auf der Oberfläche (31) übereinander angeordnete Keramikschichten (11, 12), die die Pressoberfläche (2) bilden, von denen eine der Keramikschichten eine vollflächige Keramikschicht (12) mit einem Glanzgrad **dadurch gekennzeichnet**, das die andere eine partielle Keramikschicht (11) mit einem weiteren Glanzgrad ist, der sich vom Glanzgrad der vollflächigen Keramikschicht (12) unterscheidet.

2. Presswerkzeug nach Anspruch 1, wobei die Pressoberfläche (2) eine Struktur aus Erhebungen (4) und Vertiefungen (3) aufweist, und die Grundstruktur (10) eine strukturierte Oberfläche (31) entsprechend der Struktur der Pressoberfläche (2) aufweist, wobei insbesondere die Grundstruktur (12) mehrere, übereinander angeordnete partielle Metallschichten (15) umfasst, die die strukturierte Oberfläche (31) der Grundstruktur (10) bilden.

3. Presswerkzeug nach Anspruch 1 oder 2, wobei sich die Dicke der vollflächigen Keramikschicht (12) von der Dicke der partiellen Keramikschicht (11) unterschiedet, um die unterschiedlichen Glanzgrade der vollflächigen und der partiellen Keramikschicht (11, 12) zu erhalten, wobei insbesondere die beiden Keramikschichten (11, 12) aus demselben Keramikmaterial bestehen.

4. Presswerkzeug nach Anspruch 1 oder 2, wobei sich das Keramikmaterial der beiden Keramikschichten (11, 12) unterscheidet, um die unterschiedlichen Glanzgrade der vollflächigen und der partiellen Keramikschicht (11, 12) zu erhalten, wobei insbesondere die Dicke der vollflächigen Keramikschicht (12) gleich der Dicke der partiellen Keramikschicht (11) ist.

5. Presswerkzeug nach einem der Ansprüche 1 bis 4, wobei die partielle Keramikschicht (11) zwischen der vollflächigen Keramikschicht (12) und der strukturierten Oberfläche (31) des Grundstruktur (10) angeordnet ist, oder wobei die partielle Keramikschicht (11) über der vollflächigen Keramikschicht (12) angeordnet ist.

6. Presswerkzeug nach einem der Ansprüche 1 bis 5, wobei die Dicken der Keramikschichten (11, 12) im Bereich zwischen 1µm und 2µm liegen, und/oder das Keramikmaterial der Keramikschichten (11, 12) Hafniumdiborid, Molybdändiborid, Tantaldiborid, Titandiborid, Wolframdiborid, Vanadiumdiborid, Zirkondiborid oder Mischungen dieser Keramikmaterialien ist.

7. Presswerkzeug nach einem der Ansprüche 1 bis 6, wobei die Oberfläche (31) der Grundstruktur (10) in unterschiedlichen Bereichen unterschiedliche Glanzgrade aufweist, die sich insbesondere von den Glanzgraden der vollflächigen und der partiellen Keramikschicht (11, 12) unterscheiden.

8. Verfahren zum Herstellen eines Presswerkzeugs nach einem der Ansprüche 1 bis 7, aufweisend folgende Verfahrensschritte:
- Bereitstellen der Grundstruktur (10),
- Auftragen einer der Keramikschichten (11, 12) auf die Oberfläche (31) der Grundstruktur (10), und
- Auftragen einer weiteren der Keramikschichten (11, 12) auf die auf der strukturierten Oberfläche (10) aufgetragenen Keramikschicht, wobei sich die Glanzgrade der beiden Keramikschichten (11, 12) unterscheiden.

9. Verfahren nach Anspruch 8, aufweisend
- Auftragen einer partiellen Maske auf die Oberfläche (31) der Grundstruktur (10),
- Auftragen einer Keramikschicht auf der mit der Maske versehenen strukturierten Oberfläche (31) in Bereichen, die nicht von der Maske bedeckt sind,
- Entfernen der Maske, sodass auf der strukturierten Oberfläche (31) die partielle Keramikschicht (11) angeordnet ist, und
- Auftragen der vollflächigen Keramikschicht (12) auf die partielle Keramikschicht (11).

10. Verfahren nach Anspruch 8, aufweisend
Auftragen der vollflächigen Keramikschicht (12) auf die Oberfläche (31) der Grundstruktur (10),
- Auftragen einer partiellen Maske auf die vollflächige Keramikschicht (12),
- Auftragen einer Keramikschicht auf der mit der Maske versehenen vollflächigen Keramikschicht (12) in Bereichen, die nicht von der Maske bedeckt sind,
- Entfernen der Maske, sodass auf der vollflächigen Keramikschicht (12) die partielle Keramikschicht (11) angeordnet ist.

11. Verfahren nach einem der Ansprüche 8 bis 10, aufweisend Nachbehandeln der entsprechenden aufgetragenen Keramikschicht, um einen vorgegeben Glanzgrad der entsprechenden Keramikschicht zu erhalten.

12. Verfahren nach einem der Ansprüche 8 bis 11, aufweisend Auftragen der Keramikschichten (11, 12) mittels eines Flächenmagnetronsputter-Beschichtungssystems (33), wobei insbesondere Herstellen der partiellen Keramikschicht (11) durch geeignetes Ansteuern des Flächenmagnetronsputter-Beschichtungssystems (33).

## Claims

1. A pressing tool for producing a workpiece, comprising
a pressing surface (2),
a base structure (10), which comprises a surface (31), and
at least two ceramic layers (11, 12) which are arranged on top of one another on the surface (31) and form the pressing surface (2), of which one of the ceramic layers is a full-surface ceramic layer (12) with one degree of gloss, **characterized in that** the other is a partial ceramic layer (11) with a further degree of gloss which differs from the degree of gloss of the full-surface ceramic layer (12).

2. The pressing tool according to claim 1, wherein the pressing surface (2) has a structure of protrusions (4) and recesses (3), and the base structure (10) comprises a structured surface (31) corresponding to the structure of the pressing surface (2), wherein in particular the base structure (12) comprises multiple partial metal layers (15) arranged one above the other, which form the structured surface (31) of the base structure (10).

3. The pressing tool according to claim 1 or 2, wherein the thickness of the full-surface ceramic layer (12) differs from the thickness of the partial ceramic layer (11) in order to obtain the different degrees of gloss of the full-surface and the partial ceramic layers (11, 12), wherein, in particular, the two ceramic layers (11, 12) consist of the same ceramic material.

4. The pressing tool according to claim 1 or 2, wherein the ceramic material of the two ceramic layers (11, 12) differs in order to obtain the different degrees of gloss of the full-surface and the partial ceramic layers (11, 12), wherein, in particular, the thickness of the full-surface ceramic layer (12) is equal to the thickness of the partial ceramic layer (11).

5. The pressing tool according to one of claims 1 to 4, wherein the partial ceramic layer (11) is arranged between the full-surface ceramic layer (12) and the structured surface (31) of the base structure (10), or wherein the partial ceramic layer (11) is arranged above the full-surface ceramic layer (12).

6. The pressing tool according to one of claims 1 to 5, wherein the thicknesses of the ceramic layers (11, 12) are in the range between 1µm and 2µm, and/or the ceramic material of the ceramic layers (11, 12) is hafnium diboride, molybdenum diboride, tantalum diboride, titanium diboride, tungsten diboride, vanadium diboride, zirconium diboride or mixtures of these ceramic materials.

7. The pressing tool according to one of claims 1 to 6, wherein the surface (31) of the base structure (10) has different degrees of gloss in different areas, which differ in particular from the degrees of gloss of the full-surface and the partial ceramic layers (11, 12).

8. A method for producing a pressing tool according to one of claims 1 to 7, comprising the following method steps:
- providing the base structure (10),
- applying one of the ceramic layers (11, 12) onto the surface (31) of the base structure (10), and
- applying a further one of the ceramic layers (11, 12) onto the ceramic layer applied onto the structured surface (10), wherein the degrees of gloss of the two ceramic layers (11, 12) differ.

9. The method according to claim 8, comprising
- applying a partial mask onto the surface (31) of the base structure (10),
- applying a ceramic layer onto the structured surface (31) provided with the mask in areas not covered by the mask,
- removing the mask so that the partial ceramic layer (11) is arranged on the structured surface (31), and
- applying the full-surface ceramic layer (12) onto the partial ceramic layer (11).

10. The method according to claim 8, comprising
applying the full-surface ceramic layer (12) onto the surface (31) of the base structure (10),
- applying a partial mask onto the full-surface ceramic layer (12),
- applying a ceramic layer onto the full-surface ceramic layer (12) provided with the mask in areas not covered by the mask,
- removing the mask so that the partial ceramic layer (11) is arranged on the full-surface ceramic layer (12).

11. The method according to one of claims 8 to 10, comprising subsequent treatment of the corresponding applied ceramic layer in order to obtain a predetermined degree of gloss of the corresponding ceramic layer.

12. The method according to one of claims 8 to 11, comprising application of the ceramic layers (11, 12) by means of a surface magnetron sputter coating system (33), wherein, in particular, the partial ceramic layer (11) is produced by suitably controlling the surface magnetron sputter coating system (33).

## Revendications

1. Outil de presse pour la fabrication d'une pièce, comprenant
une surface de pression (2),
une structure de base (10), qui présente une surface (31) et
au moins deux couches de céramique (11, 12) disposées sur la surface (31), qui forment la surface de pression (2), une des couches de céramique étant une couche de céramique entière (12) avec un degré de brillance, **caractérisé en ce que** l'autre est une couche de céramique partielle (11) avec un autre degré de brillance qui est différent du degré de brillance de la couche de céramiqueentière (12).

2. Outil de presse selon la revendication 1, dans lequel la surface de pression (2) présente une structure constituée de bossages (4) et de creux (3) et la structure de base (10) présente une surface structurée (31) correspondant à la surface de pression (2), dans lequel, plus particulièrement, la structure de base (12) comprend plusieurs couches métalliques partielles (15) superposées, qui forment la surface structurée (31) de la structure de base (10).

3. Outil de presse selon la revendication 1 ou 2, dans lequel l'épaisseur de la couche de céramique entière (12) est différente de l'épaisseur de la couche de céramique partielle (11) afin d'obtenir les différents degrés de brillance des couches de céramique entière et partielle (11, 12), dans lequel, plus particulièrement, les deux couches de céramique (11, 12) sont constituées du même matériau de type céramique.

4. Outil de presse selon la revendication 1 ou 2, dans lequel les matériaux de type céramique des deux couches de céramique (11, 12) sont différents, afin d'obtenir les différents degrés de brillance des couches de céramique entière et partielle (11, 12), dans lequel, plus particulièrement, l'épaisseur de la couche de céramique entière (12) est égale à l'épaisseur de la couche de céramique partielle (11).

5. Outil de presse selon l'une des revendications 1 à 4, dans lequel la couche de céramique partielle (11) est disposée entre la couche de céramique entière (12) et la surface structurée (31) de la structure de base (10) ou dans lequel la couche de céramique partielle (11) est disposée au-dessus de la couche de céramique entière (12).

6. Outil de presse selon l'une des revendications 1 à 5, dans lequel les épaisseurs des couches de céramique (11, 12) sont de 1 µm à 2 µm et/ou le matériau de type céramique des couches de céramique (11, 12) est du diborure de hafnium, du diborure de molybdène, du diborure de tantale, du diborure de titane, du diborure de tungstène, du diborure de vanadium, du diborure de zirconium ou des mélanges de ces matériaux de type céramique.

7. Outil de presse selon l'une des revendications 1 à 6, dans lequel la surface (31) de la structure de base (10) présente, dans des zones différentes, des degrés de brillance différents, qui sont, plus particulièrement, différents des degrés de brillance des couches de céramique entière et partielle (11, 12).

8. Procédé de fabrication d'un outil de presse selon l'une des revendications 1 à 7, comprenant les étapes suivantes
- mise à disposition de la structure de base (10),
- application d'une des couches de céramique (11, 12) sur la surface (31) de la structure de base (10) et
- application d'une autre des couches de céramique (11, 12) sur la couche de céramique appliquée sur la surface structurée (10), dans lequel les degrés de brillance des deux couches de céramique (11, 12) sont différentes entre elles.

9. Procédé selon la revendication 8, comprenant
- l'application d'un masque partiel sur la surface (31) de la structure de base (10),
- l'application d'une couche de céramique sur surface structurée (31) munie du masque dans des zones qui ne sont pas recouvertes par le masque,
- le retrait du masque, de sorte que la couche de céramique partielle (11) est disposée sur la surface structurée (31) et
- l'application de la couche de céramique entière (12) sur la couche de céramique partielle (11).

10. Procédé selon la revendication 8, comprenant
- l'application de la couche de céramique entière (12) sur la surface (31) de la structure de base (10),
- l'application d'un masque partiel sur la couche de céramique entière (12),
- l'application d'une couche de céramique sur la couche de céramique entière (12) munie du masque dans des zones qui ne sont pas recouvertes par le masque,
- le retrait du masque de sorte que la couche de céramique partielle (11) est disposée sur la couche de céramique entière (12).

11. Procédé selon l'une des revendications 8 à 10, comprenant le post-traitement de la couche de céramique appliquée de manière correspondante, afin d'obtenir un degré de brillance prédéterminé de la couche de céramique correspondante.

12. Procédé selon l'une des revendications 8 à 11, comprenant l'application des couches de céramique (11, 12) au moyen d'un système de revêtement par pulvérisation par magnétron de surface (33), dans lequel, plus particulièrement, dans lequel la réalisation de la couche de céramique partielle (11) est effectuée à l'aide d'un contrôle approprié du système de revêtement par pulvérisation par magnétron de surface (33).
